# EUROPEAN PATENT APPLICATION

(11) **EP 4 645 289 A1**
(43) Date of publication of application: **05.11.2025**
(21) Application number: 24766173.9
(22) Date of filing: 08.01.2024
(51) Int. Cl.: G09F 9/30

(54) **FOLDABLE DISPLAY TERMINAL AND MIDDLE FRAME**

(30) Priority: 09.03.2023 CN 202310261747
(71) Applicant: Huawei Technologies Co., Ltd., Shenzhen, Guangdong 518129 (CN)
(72) Inventor: ZHANG, Min, Shenzhen, Guangdong 518129 (CN); HUA, Leilei, Shenzhen, Guangdong 518129 (CN); WU, Weifeng, Shenzhen, Guangdong 518129 (CN); LI, Zheng, Shenzhen, Guangdong 518129 (CN); SHAN, Wei, Shenzhen, Guangdong 518129 (CN); MA, Chunjun, Shenzhen, Guangdong 518129 (CN); YOU, Yulin, Shenzhen, Guangdong 518129 (CN)
(74) Representative: MERH-IP Matias Erny Reichl Hoffmann Patentanwälte PartG mbB
(86) International application number: PCT/CN2024/071232
(87) International publication number: WO 2024/183450

(57) **Abstract**

This application provides a foldable display terminal and a middle frame used in the foldable display terminal. The foldable display terminal includes a hinge structure, and a first middle frame and a second middle frame that are located on two sides of the hinge structure. An edge of the first middle frame includes a first top surface, an edge of the second middle frame includes a second top surface, the first top surface includes a first protrusion part, and the second top surface includes a second protrusion part. When the foldable display terminal is in a folded state, the first top surface faces the second top surface, a gap exists between the first top surface and the second top surface, the first protrusion part faces the second protrusion part, and a gap exists between the first protrusion part and the second protrusion part. In this case, squeezing between the two middle frames when the foldable display terminal in the folded state falls can be reduced through mutual support between the protrusion parts.

## Description

This application claims priority to Chinese Patent Application No. 202310261747.1, filed with the China National Intellectual Property Administration on March 9, 2023 and entitled "FOLDABLE DISPLAY TERMINAL AND MIDDLE FRAME", which is incorporated herein by reference in its entirety.

### TECHNICAL FIELD

This application relates to the field of display electronic product technologies, and in particular, to a foldable display terminal and a middle frame that may be used in the foldable display terminal.

### BACKGROUND

Currently, foldable displays are widely used in mobile terminals such as a foldable mobile phone and a foldable tablet computer. These foldable electronic devices each mainly include two middle frames, and the two middle frames are connected by using a hinge structure, to implement flattening and folding of the foldable display.

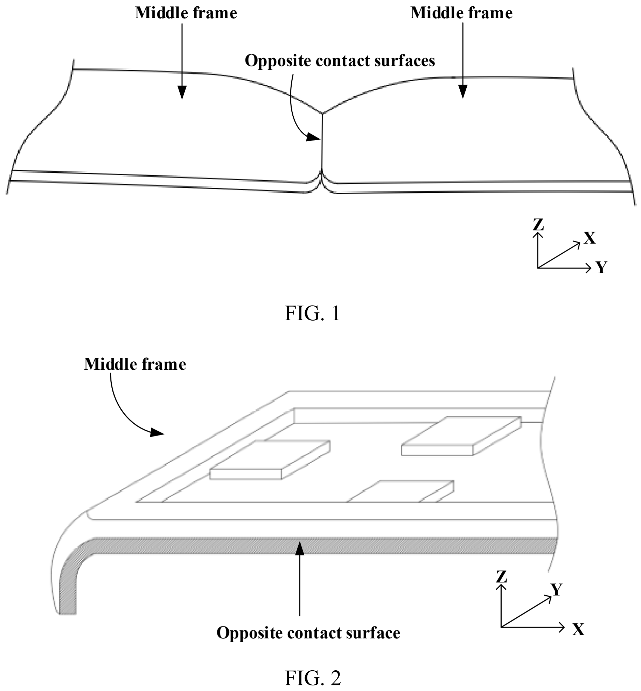

The foldable electronic devices may fall to ground during use, and the foldable electronic devices are more vulnerable to damage than non-foldable electronic devices in falling scenarios due to more complex structures. For example, FIG. 1 shows a scenario in which a foldable electronic device falls when being unfolded. In the scenario, opposite contact surfaces between two middle frames are mutually supported, so that an internal structure of the device is not squeezed.

However, as a device becomes lighter and thinner in appearance, and appearance forms are diversified, as shown in FIG. 2, widths of opposite contact surfaces between middle frames in a Z direction become narrower, worsening an effect of mutual support between the two middle frames. When the device falls to the ground, the middle frames are likely to be misaligned in an X direction or the Z direction, as shown in FIG. 1. In this case, a hinge and a screen are likely to be squeezed, resulting in a black spot or a line failure on the screen.

### SUMMARY

This application provides a foldable display terminal and a middle frame that may be used in the foldable display terminal. A main purpose is to reduce a degree of mutual squeezing between middle frames when the foldable display terminal falls, to ensure that internal electronic components or other internal structures are basically not subject to great squeezing and impact.

To achieve the foregoing objectives, the following technical solutions are used in embodiments of this application.

According to one aspect, this application provides a foldable display terminal. For example, the foldable display terminal may be a foldable mobile phone, a foldable tablet computer, or the like.

The foldable display terminal includes a first middle frame, a second middle frame, and a hinge structure. The first middle frame and the second middle frame are disposed on two sides of the hinge structure, and the first middle frame and the second middle frame rotate toward each other through the hinge structure, so that the foldable display terminal is capable of performing switching between a flattened state and a folded state. When the foldable display terminal is in the flattened state, the first middle frame and the second middle frame are in a flattened disposition.

In addition, an edge of the first middle frame includes a first top surface, an edge of the second middle frame includes a second top surface, the first top surface includes a first protrusion part, and the second top surface includes a second protrusion part. When the foldable display terminal is in the folded state, the first top surface faces the second top surface, a gap exists between the first top surface and the second top surface, the first protrusion part faces the second protrusion part, and a gap exists between the first protrusion part and the second protrusion part.

In the foldable display terminal provided in this application, the first protrusion part is disposed on the first top surface at the edge of the first middle frame, and the second protrusion part is disposed on the second top surface at the edge of the second middle frame; and when the foldable display terminal is in the folded state, the first top surface faces the second top surface, the gap exists between the first top surface and the second top surface, the first protrusion part faces the second protrusion part, and the gap exists between the first protrusion part and the second protrusion part. Therefore, when the display terminal in the folded state falls, and a falling direction is parallel to a direction in which the first middle frame and the second middle frame are stacked (namely, a thickness direction parallel to the foldable display terminal), the first protrusion part and the second protrusion part may abut against each other for mutual support, so that a falling amount of the first middle frame or the second middle frame can be reduced, to reduce a degree of mutual squeezing between the two middle frames, basically protect an internal structure of the device from further squeezing and impact, and reduce a probability of damage to the internal structure due to large impact.

In a possible implementation, the first protrusion part is disposed at a position that is of the first top surface and that is close to an end of the hinge structure; and the second protrusion part is disposed at a position that is of the second top surface and that is close to an end of the hinge structure.

In this embodiment, the first protrusion part and the second protrusion part are respectively disposed at positions that of the corresponding middle frames and that are close to the end of the hinge structure. An appearance and aesthetics of a product can be optimized in comparison with disposing the protrusion parts at other positions.

In a possible implementation, a surface that is of the first protrusion part and that is suitable for facing the second protrusion part when the foldable display terminal is in the folded state is a plane, and a surface that is of the second protrusion part and that is suitable for facing the first protrusion part when the foldable display terminal is in the folded state is a plane.

Therefore, when the display terminal in the folded state falls in the direction in which the first middle frame and the second middle frame are stacked, the first protrusion part and the second protrusion part are in surface contact with each other, to provide a good mutual support effect and further reduce a degree of squeezing between the two middle frames.

In a possible implementation, when the foldable display terminal is in the folded state, the gap between the first protrusion part and the second protrusion part is d1, where d1≤1 mm.

For example, 0.1 mm≤d1≤0.3 mm. For another example, 0.1 mm≤d1≤0.8 mm.

If the gap d1 is large, when the foldable display terminal falls, the first protrusion part and the second protrusion part may fail to abut against each other for support.

In a possible implementation, the first protrusion part includes a first side surface, and the second protrusion part includes a second side surface. The end of the hinge structure includes a shielding member, and the shielding member includes a third top surface, a third side surface, and a fourth side surface. The first protrusion part and the shielding member are spaced from each other. The second protrusion part and the shielding member are spaced from each other. When the foldable display terminal is in the flattened state, the first protrusion part, the shielding member, and the second protrusion part are sequentially arranged in a direction in which the first middle frame points to the second middle frame, the first side surface faces the third side surface, the second side surface faces the fourth side surface, a gap exists between the first side surface and the third side surface, and a gap exists between the second side surface and the fourth side surface.

When the foldable display terminal in the flattened state falls, if the first middle frame is first grounded, the second protrusion part of the second middle frame and the shielding member may abut against each other for mutual support; or if the second middle frame is first grounded, the first protrusion part of the first middle frame and the shielding member may abut against each other for mutual support, so that the falling amount of the first middle frame or the second middle frame is reduced, to reduce a degree of mutual squeezing between the two middle frames, basically protect the internal structure of the device from further squeezing and impact, and reduce the probability of damage to the internal structure due to large impact. Particularly, when opposite contact surfaces between the two middle frames do not fully support each other due to a limited appearance size of the entire foldable display terminal, the protrusion part (the first protrusion part or the second protrusion part) and the shielding member can abut against each other for mutual support, so that the internal structure of the device can be well protected. In a possible implementation, when the foldable display terminal is in the flattened state, the gap between the first side surface and the third side surface is d2, and the gap between the second side surface and the fourth side surface is d3, where the gap d2 may be equal to the gap d3, or the gap d2 may be not equal to the gap d3.

In a possible implementation, d2≤1 mm.

For example, 0.1 mm≤d2≤0.3 mm. For another example, 0.1 mm≤d2≤0.8 mm.

If the gap d2 is large, when the foldable display terminal falls, the first protrusion part and the shielding member may fail to abut against each other for support.

In a possible implementation, the first side surface of the first protrusion part is a plane, and the second side surface of the second protrusion part is a plane.

Therefore, when the foldable display terminal falls, the first protrusion part and the shielding member abut against each other for support, or the second protrusion part and the shielding member abut against each other for support, through surface contact instead of line contact or point contact, to provide a good mutual support effect and further reduce a degree of squeezing between the two middle frames.

In a possible implementation, when the foldable display terminal is in the folded state, the first side surface faces the third top surface, the second side surface faces the third top surface, a gap exists between the first side surface and the third top surface, and a gap exists between the second side surface and the third top surface.

When the foldable display terminal in the folded state falls and the hinge structure faces downward, the first protrusion part and the shielding member may abut against each other for mutual support, and the second protrusion part and the shielding member may abut against each other for mutual support, so that the falling amount of the first middle frame or the second middle frame is reduced, to reduce a degree of mutual squeezing between the two middle frames, basically protect the internal structure of the device from further squeezing and impact, and reduce the probability of damage to the internal structure due to large impact.

In a possible implementation, when the foldable display terminal is in the folded state, the gap between the first side surface and the third top surface is d4, where d4≤1 mm. In a possible implementation, the hinge structure includes a main shaft; an end of the main shaft includes the shielding member; and when the foldable display terminal is in the flattened state, the first top surface and the second top surface are flush with the third top surface.

The top surfaces of the two protrusion parts are flush with the top surface of the shielding member, so that an appearance and aesthetics of the foldable display terminal can be optimized.

In a possible implementation, the shielding member and the main shaft are an integrally formed member.

From the perspective of an assembly process, the shielding member does not need to be assembled separately, which can simplify the assembly process.

In a possible implementation, the foldable display terminal further includes a decoration member, and the decoration member covers an outer side of the hinge structure; and when the foldable display terminal is in the flattened state, in a thickness direction of the foldable display terminal, the shielding member extends in a direction away from the decoration member; or when the foldable display terminal is in the folded state, at least parts of the decoration member and the shielding member are exposed outside the foldable display terminal.

In this embodiment, the shielding member not only has a shielding function, but also can optimize an appearance and aesthetics of the terminal product.

In a possible implementation, a first mounting groove is provided at a position that is of the first middle frame and that is close to the second middle frame, a second mounting groove is provided at a position that is of the second middle frame and that is close to the first middle frame, and the hinge structure is disposed in an accommodating groove enclosed by the first mounting groove and the second mounting groove. At a position that is of the first middle frame and that is close to the first protrusion part, a first inner wall surface used to enclose the first mounting groove is recessed toward a first outer wall surface, to form a first groove. At a position that is of the second middle frame and that is close to the second protrusion part, a second inner wall surface used to enclose the second mounting groove is recessed toward a second outer wall surface, to form a second groove. The shielding member is located in an accommodating groove enclosed by the first groove and the second groove. The first inner wall surface is opposite to the first outer wall surface, and the second inner wall surface is opposite to the second outer wall surface.

The shielding member is disposed in the accommodating groove formed by the first middle frame and the second middle frame, and is close to the first protrusion part of the first middle frame and the second protrusion part of the second middle frame. In this way, during falling, mutual support is implemented, and the terminal may be structurally compact. This meets a development trend of a miniaturization and lightness design.

In a possible implementation, a gap exists between the first outer wall surface and a wall surface that is of the first protrusion part and that faces outside of the first middle frame.

In this way, the protruding first protrusion part and the protruding second protrusion part are basically invisible from outside the foldable display terminal, so that an appearance and aesthetics of the product are optimized.

In a possible implementation, the foldable display terminal further includes a foldable display, where the foldable display is located on a side facing the first top surface and the second top surface. When the foldable display terminal is in the flattened state, a surface that is of the first protrusion part and that is away from the first top surface protrudes from the foldable display, and a surface that is of the second protrusion part and that is away from the second top surface protrudes from the foldable display.

In this design, when the foldable display of the foldable display terminal falls toward the ground, because the surface that is of the first protrusion part and that is away from the first top surface protrudes from the foldable display, and the surface that is of the second protrusion part and that is away from the second top surface protrudes from the foldable display, the foldable display can be prevented from being first grounded, to reduce a degree of damage to the foldable display.

In a possible implementation, when the foldable display terminal is in the folded state, an orthographic projection of the first protrusion part on the second top surface at least partially overlaps an orthographic projection of the second protrusion part on the second top surface.

The orthographic projection of the first protrusion part on the second top surface at least partially overlaps the orthographic projection of the second protrusion part on the second top surface. In this way, the first protrusion part and the second protrusion part abut against each other for mutual support, only when the display terminal in the folded state falls in the direction in which the first middle frame and the second middle frame are stacked.

In a possible implementation, when the foldable display terminal is in the folded state, an orthographic projection of the first protrusion part on a reference surface at least partially overlaps an orthographic projection of the shielding member on the reference surface. The reference surface is perpendicular to the first top surface, and is parallel to an axial direction of the hinge structure.

When the foldable display terminal in the folded state falls and the hinge structure faces downward, the first protrusion part and the shielding member may abut against each other for mutual support, and the second protrusion part and the shielding member may abut against each other for mutual support.

In a possible implementation, the first protrusion part and the first middle frame are an integrally formed member.

For example, the first protrusion part and the first middle frame may be integrally formed into a metal structural part by using a casting process.

According to another aspect, this application further provides a middle frame. The middle frame is disposed on one side of a hinge structure in a foldable display terminal and is capable of rotating through the hinge structure. The middle frame includes a middle frame body and a side frame. The side frame is connected to an outer circumferential edge of the middle frame body. The side frame includes a first top surface, and the first top surface includes a first protrusion part. When the middle frame rotates to a folded state through the hinge structure, the first top surface faces a second top surface of another middle frame, a gap exists between the first top surface and the second top surface, the first protrusion part faces a second protrusion part on the second top surface, and a gap exists between the first protrusion part and the second protrusion part.

For the middle frame that is provided in this application and may be used in the foldable display terminal (for example, a foldable mobile phone or a foldable tablet computer), there are protrusion parts on edge surfaces, a first middle frame and a second middle frame with such a structure are disposed on two sides of the hinge structure, and when the foldable display terminal is folded, a gap exists between the two protrusion parts. In this way, when the display terminal in a folded state falls in a thickness direction of the foldable display terminal, the two protrusion parts can abut against each other for mutual support, so that a falling amount of the middle frame can be reduced, to reduce a degree of mutual squeezing between the two middle frames, basically protect an internal structure of the device from further squeezing and impact, and reduce a probability of damage to the internal structure due to large impact.

In a possible implementation, the first protrusion part is disposed at a position that is of the first top surface and that is close to an end of the hinge structure.

This embodiment of this application can optimize an appearance and aesthetics of a product compared with an embodiment in which the first protrusion part is disposed at another position.

In a possible implementation, the first protrusion part and the side frame are an integrally formed member.

In a possible implementation, the side frame and the middle frame body are an integrally formed member.

In a possible implementation, a first mounting groove is provided at a position that is of the side frame and that is close to the hinge structure, and the first mounting groove is configured to accommodate the hinge structure. At a position that is of the side frame and that is close to the first protrusion part, a first inner wall surface used to enclose the first mounting groove is recessed toward a first outer wall surface, to form a first groove, the first groove is configured to dispose a shielding member located at the end of the hinge structure, the first inner wall surface is opposite to the first outer wall surface, and a gap exists between the first outer wall surface and a wall surface that is of the first protrusion part and that faces outside of the middle frame.

The shielding member is disposed in an accommodating groove formed by the first middle frame and the second middle frame, and is close to the first protrusion part of the side frame. In this way, during falling, mutual support is implemented, and the terminal may be structurally compact.

In addition, a gap exists between the first outer wall surface and the wall surface that is of the first protrusion part and that faces outside of the middle frame. In this way, the protruding first protrusion part is basically invisible from outside the foldable display terminal, so that an appearance and aesthetics of the product are optimized.

### BRIEF DESCRIPTION OF DRAWINGS

FIG. 1 is a diagram of a simple structure of a foldable display terminal in which two middle frames abut against each other;
FIG. 2 is a diagram of a partial structure of a middle frame in a foldable display terminal;
FIG. 3 is an exploded view of a foldable display terminal according to an embodiment of this application;
FIG. 4 is an exploded view of a foldable display terminal according to an embodiment of this application;
FIG. 5 is an exploded view of a first middle frame and a hinge structure in a foldable display terminal according to an embodiment of this application;
FIG. 6 is a diagram of a partial structure of a first middle frame in a foldable display terminal according to an embodiment of this application;
FIG. 7 is an exploded view of a second middle frame and a hinge structure in a foldable display terminal according to an embodiment of this application;
FIG. 8 is a diagram of a partial structure of a second middle frame in a foldable display terminal according to an embodiment of this application;
FIG. 9 is a diagram of a falling scenario of a foldable display terminal according to an embodiment of this application;
FIG. 10 is a diagram of another falling scenario of a foldable display terminal according to an embodiment of this application;
FIG. 11 is a diagram of a structure of a first middle frame in a foldable display terminal according to an embodiment of this application;
FIG. 12 is a diagram of a partial structure of a first middle frame in a foldable display terminal according to an embodiment of this application;
FIG. 13 is a diagram of a structure of a second middle frame in a foldable display terminal according to an embodiment of this application;
FIG. 14 is a diagram of a partial structure of a first middle frame in a foldable display terminal according to an embodiment of this application;
FIG. 15 is a diagram of a structure of a foldable display terminal in a folded state according to an embodiment of this application;
FIG. 16 is an enlarge view of a position B in FIG. 15;
FIG. 17 is a diagram of a structure of a hinge structure and a shielding member in a foldable display terminal according to an embodiment of this application;
FIG. 18 is a diagram of a structure of a foldable display terminal in a flattened state according to an embodiment of this application;
FIG. 19A is a diagram of a partial structure in FIG. 18;
FIG. 19B is a diagram in a direction C in FIG. 18;
FIG. 20 is a diagram of a structure of a hinge structure and a shielding member in a foldable display terminal according to an embodiment of this application;
FIG. 21 is a diagram of a structure of a hinge structure, a shielding member, and a decoration member in a foldable display terminal according to an embodiment of this application;
FIG. 22 is an exploded view of FIG. 21;
FIG. 23 is a diagram of a structure of a foldable display terminal in a flattened state according to an embodiment of this application;
FIG. 24 is an enlarged view of a position D1 or a position D2 in FIG. 23;
FIG. 25 is an enlarged view of a position D1 or a position D2 in FIG. 23 from another angle of view;
FIG. 26 is a diagram of a position relationship between a first protrusion part and a shielding member in a foldable display terminal according to an embodiment of this application;
FIG. 27 is a diagram of a structure of a foldable display terminal in a folded state according to an embodiment of this application;
FIG. 28 is an enlarged view of a position E in FIG. 27;
FIG. 29 is an enlarged view of a position E in FIG. 27 from another angle of view;
FIG. 30 is a diagram of a position relationship between a first protrusion part and a shielding member in a foldable display terminal according to an embodiment of this application;
FIG. 31 is a diagram of a structure of a foldable display terminal in a flattened state according to an embodiment of this application;
FIG. 32 is an enlarged view of a position F in FIG. 31;
FIG. 33 is a diagram of a structure of a first middle frame in a foldable display terminal according to an embodiment of this application;
FIG. 34 is an enlarged view of a position G in FIG. 33;
FIG. 35 is a diagram of a structure of a first protrusion part in a foldable display terminal according to an embodiment of this application; and
FIG. 36 is a diagram of a structure of a shielding member in a foldable display terminal according to an embodiment of this application.

### Reference numerals:

100: foldable display terminal;
011: first middle frame;
012: second middle frame;
02: hinge structure; 021: main shaft;
03: foldable display;
1: accommodating groove;
2: shielding member;
31: first protrusion part;
32: second protrusion part;
4: decoration member.

### DESCRIPTION OF EMBODIMENTS

An embodiment of this application provides a foldable display terminal. The foldable display terminal may include various electronic devices with foldable displays, in which an unfolded form or a folded form of the foldable displays and the foldable display terminal can be changed. Based on different use requirements, the foldable display terminal may be unfolded to a flattened state, or may be folded to a folded state, or may be in an intermediate state between the flattened state and the folded state. In other words, the foldable display terminal has at least two states, that is, the flattened state and the folded state. In some cases, the foldable display terminal may further have a third state, namely, the intermediate state between the flattened state and the folded state. It may be understood that the intermediate state is not unique, and may be any one or more states between the flattened state and the folded state of the foldable display terminal.

For example, the foldable display terminal may include but is not limited to a mobile phone, a tablet computer, a notebook computer, an e-book reader, a camera, a wearable device, a home electronic device, or the like. For ease of understanding, in embodiments of this application, an example in which the foldable display terminal is a mobile phone is used for description.

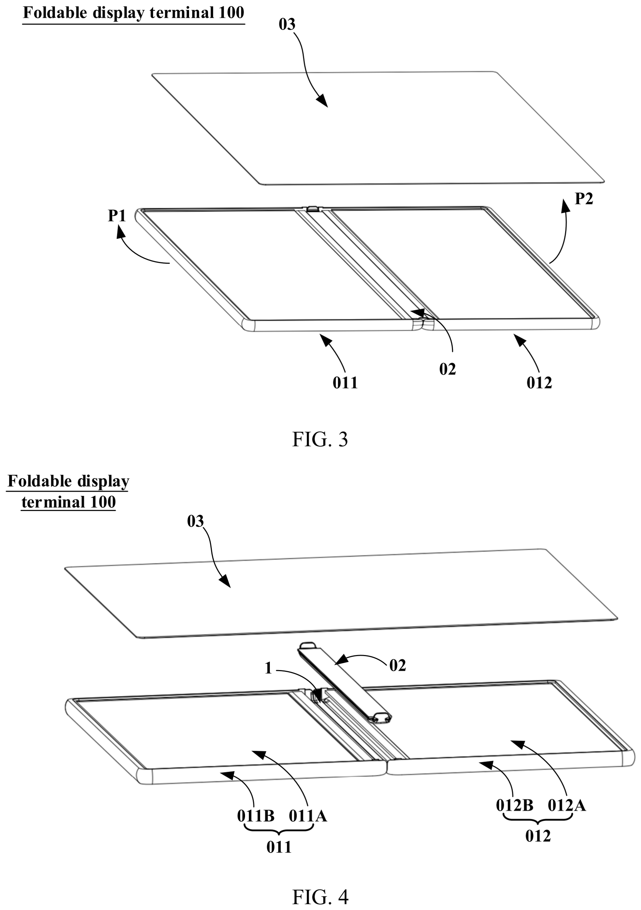

Refer to FIG. 3 and FIG. 4. FIG. 3 is an exploded view of a foldable display terminal 100 in a flattened state according to an embodiment of this application. FIG. 4 is a further exploded view of the foldable display terminal 100 in the flattened state according to this embodiment of this application. With reference to FIG. 3 and FIG. 4, the foldable display terminal 100 may include a hinge structure 02, a first middle frame 011, a second middle frame 012, and a foldable display 03.

The first middle frame 011 and the second middle frame 012 are disposed on two opposite sides of the hinge structure 02, and are separately connected to the hinge structure 02. The hinge structure 02 can move, so that the first middle frame 011 and the second middle frame 012 are folded or unfolded relative to each other. When the first middle frame 011 and the second middle frame 012 are folded, the foldable display terminal 100 may be in a folded state. When the first middle frame 011 and the second middle frame 012 are unfolded, the foldable display terminal 100 may be in the flattened state.

Still refer to FIG. 3 and FIG. 4. The foldable display 03 may continuously cover the first middle frame 011 and the second middle frame 012 of the foldable display terminal 100, and a same side surface of the hinge structure 02. In addition, one part of the foldable display 03 may be fastened onto the first middle frame 011, and the other part may be fastened onto the second middle frame 012. In this way, when the first middle frame 011 and the second middle frame 012 move toward or away from each other, the foldable display 03 may be driven to fold or flatten.

The foldable display 03 can be configured to: display information and provide an interaction interface for a user. In embodiments of this application, the foldable display 03 may include but is not limited to an organic light-emitting diode (organic light-emitting diode, OLED) display, an active-matrix organic light-emitting diode (active-matrix organic light-emitting diode, AMOLED) display, a mini light-emitting diode (mini light-emitting diode) display, a micro light-emitting diode (micro light-emitting diode) display, a micro organic light-emitting diode (micro organic light-emitting diode) display, a quantum dot light-emitting diode (quantum dot light-emitting diode, QLED) display, or the like. As described above, the foldable display terminal 100 can perform switching between the flattened state and the folded state through moving of the hinge structure 02, and the foldable display 03 can be folded or unfolded with the first middle frame 011 and the second middle frame 012.

For example, a folding manner of the foldable display terminal includes an inward-folding manner and an outward-folding manner.

The outward-folding manner means that, in a process in which the display terminal performs switching from the flattened state to the folded state, and when the display terminal is in the folded state, the foldable display 03 is located on an outer side of the display terminal. To be specific, in a folding process and in the folded state, the foldable display 03 is still visible to the user; and in the folded state, the user may further perform some operations on the foldable display 03.

Correspondingly, the inward-folding manner means that, in a process in which the display terminal performs switching from the flattened state to the folded state, and when the display terminal is in the folded state, the foldable display 03 is located on an inner side of the foldable display terminal 100. To be specific, in a folding process, the foldable display 03 is gradually invisible to the user until the foldable display 03 is accommodated and hidden between the two middle frames in the folded state. For example, in the foldable display terminal 100 shown in FIG. 3, when the first middle frame 011 rotates in a direction P1 and the second middle frame 012 rotates in a direction P2, the foldable display 03 is located on the inner side of the foldable display terminal 100 until the foldable display 03 is accommodated and hidden between the two middle frames in the folded state. In this case, the foldable display terminal 100 may be referred to as an inward-folded electronic product.

Any middle frame provided in embodiments of this application may include a middle frame body and a side frame connected to an outer circumferential edge of the middle frame body. For example, in FIG. 4, the first middle frame 011 includes a first middle frame body 011A and a first side frame 011B connected to an outer circumferential edge of the first middle frame body 011A, and the second middle frame 012 includes a second middle frame body 012A and a second side frame 012B connected to an outer circumferential edge of the second middle frame body 012A.

In some examples, a side that is of the first middle frame 011 and the second middle frame 012 and that is away from the foldable display 03 has a rear cover plate. Either of the first middle frame body 011A and the second middle frame body 012A may form mounting space with the rear cover plate, to mount electronic components of the foldable display terminal, such as a circuit board, a battery, a receiver, a speaker, and a camera. The circuit board may integrate electronic components of the foldable display terminal, such as a main controller, a storage unit, an antenna module, and a power management module. The battery may supply power to electronic components such as the foldable display 03, the circuit board, the receiver, the speaker, and the camera.

In some structures, the first middle frame body 011A and the first side frame 011B in FIG. 4 may be an integrally formed member. Alternatively, in some other structures, the first middle frame body 011A and the first side frame 011B may be structural parts independent of each other, and during assembly, the first middle frame body 011A may be connected to the first side frame 011B by using a connection structure, for example, an adhesive layer or a connecting part such as a screw.

Similarly, the second middle frame body 012A and the second side frame 012B of the second middle frame 012 may also be an integrally formed member, or may be two independent structural parts that need to be connected by using a connecting part.

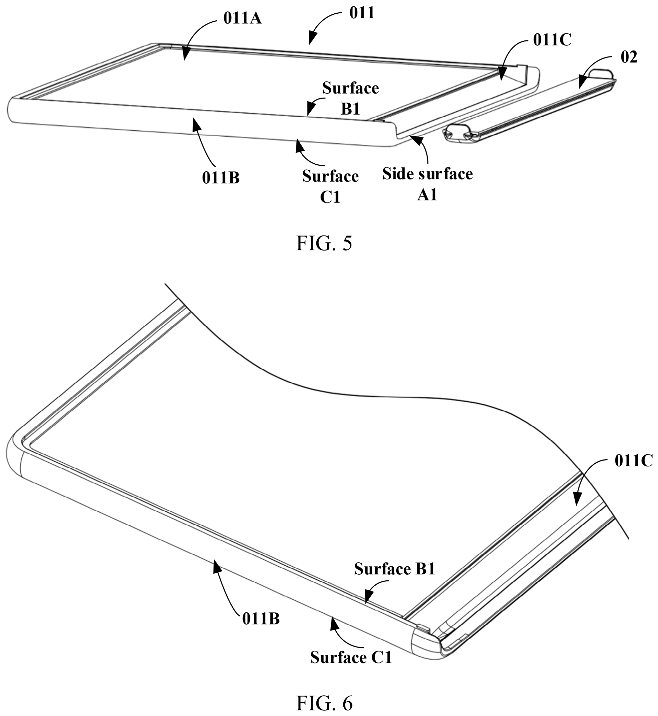

Refer to FIG. 5 and FIG. 6. FIG. 5 is an exploded view of the first middle frame 011 and the hinge structure 02. FIG. 6 is a diagram of a partial structure of the first middle frame 011 from another angle of view. With reference to FIG. 5 and FIG. 6, the first side frame 011B of the first middle frame 011 includes a side surface A1, and a surface B1 and a surface C1 that are opposite to each other.

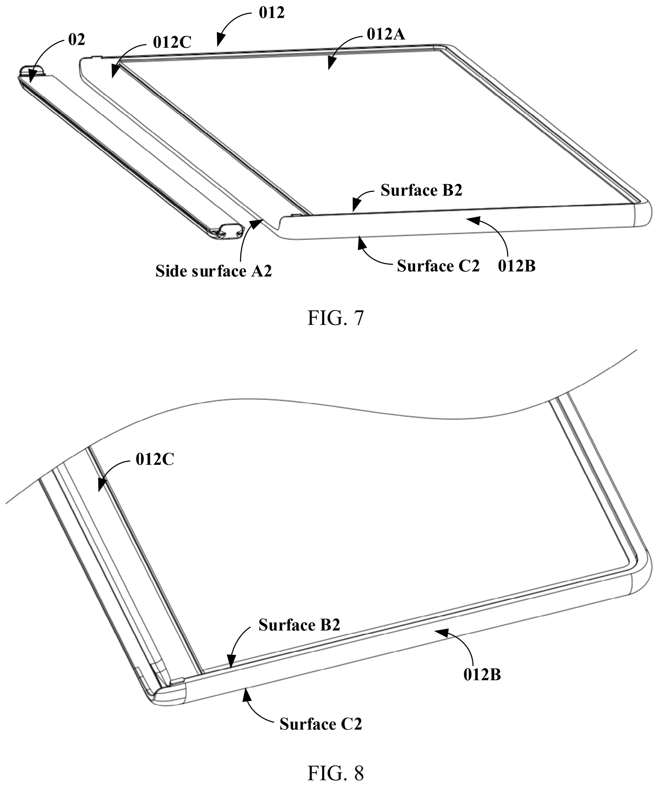

Refer to FIG. 7 and FIG. 8. FIG. 7 is an exploded view of the second middle frame 012 and the hinge structure 02. FIG. 8 is a diagram of a partial structure of the second middle frame 012 from another angle of view. With reference to FIG. 7 and FIG. 8, the second side frame 012B of the second middle frame 012 includes a side surface A2, and a surface B2 and a surface C2 that are opposite to each other.

When the foldable display terminal is in the flattened state, the side surface A1 and the side surface A2 are opposite to each other. In addition, as shown in FIG. 5 and FIG. 6, there is a mounting groove 011C at a position that is of the first middle frame 011 and that is close to the second middle frame 012. As shown in FIG. 7 and FIG. 8, there is a mounting groove 012C at a position that is of the second middle frame 012 and that is close to the first middle frame 011. The mounting groove 011C and the mounting groove 012C may enclose an accommodating groove 1 used to dispose the hinge structure 02 (see FIG. 4).

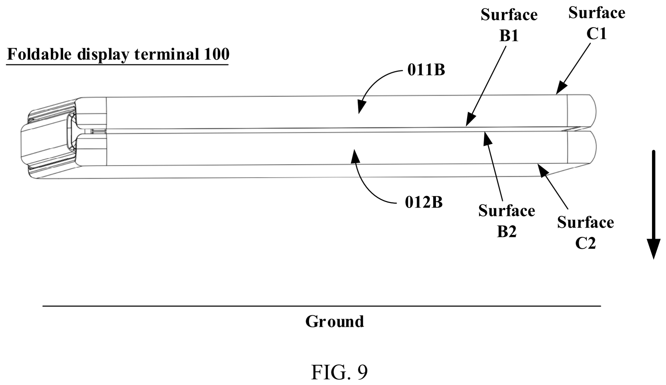

When the first middle frame 011 and the second middle frame 012 rotate toward each other, the surface B1 of the first side frame 011B is closer to the second middle frame 012 relative to the surface C1, and the surface B2 of the second side frame 012B is closer to the first middle frame 011 relative to the surface C2. In other words, when the first middle frame 011 and the second middle frame 012 rotate toward each other, the surface B1 of the first side frame 011B and the surface B2 of the second side frame 012B are close to each other, to implement folding of the foldable display. For example, when the foldable display terminal 100 is in the folded state shown in FIG. 9, the surface B1 of the first side frame 011B faces the surface B2 of the second side frame 012B.

When the first middle frame 011 and the second middle frame 012 rotate away from each other, the surface B1 of the first side frame 011B and the surface B2 of the second side frame 012B are away from each other, to implement flattening of the foldable display.

In the first middle frame 011 and the second middle frame 012 shown in FIG. 5 to FIG. 8, the foldable display 03 may be disposed on one side facing the surface B1 and the surface B2. In this case, when the first middle frame 011 and the second middle frame 012 rotate toward each other, the foldable display 03 is gradually hidden between the first middle frame 011 and the second middle frame 012. Therefore, the foldable display terminal 100 is an inward-folded structure.

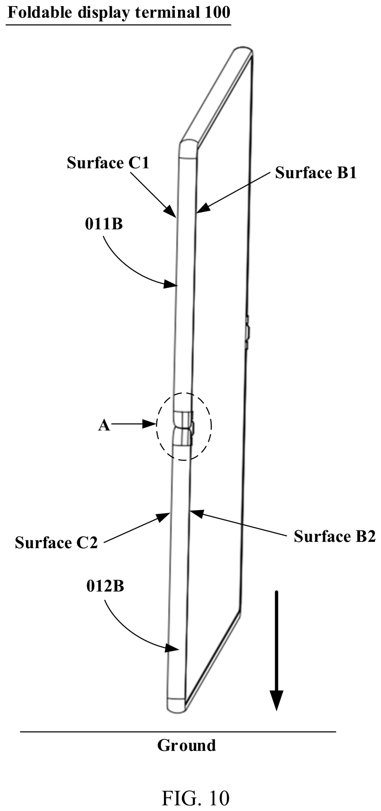

The foldable display terminal 100 inevitably falls to the ground during use. For example, FIG. 9 and FIG. 10 respectively show two different scenarios in which the foldable display terminal 100 falls to the ground.

In FIG. 9, when the foldable display terminal 100 in the folded state falls in a thickness direction (pointed by a black arrow in FIG. 9) of the foldable display terminal 100, the surface B1 of the first side frame 011B and the surface B2 of the second side frame 012B may be in contact with each other or even squeezed.

In FIG. 10, when the foldable display terminal 100 in the flattened state falls in a direction (pointed by a black arrow in FIG. 10) that is roughly parallel to a direction in which the first side frame 011B and the second side frame 012B are arranged, the side surface A1 of the first side frame 011B in FIG. 5 and the side surface A2 of the second side frame 012B in FIG. 7 may be in contact with each other or even be squeezed, for example, a position A shown in FIG. 10 may be squeezed.

In the two different falling scenarios shown in FIG. 9 and FIG. 10, or in other different falling scenarios, because the two middle frames are squeezed against each other, an electronic component integrated into the middle frame or the foldable display is prone to damage due to energy generated by falling impact.

To reduce energy impact on an internal structure and the electronic component of the entire foldable display terminal, in this embodiment of this application, a structural part is improved, to protect the internal structure of the foldable display terminal. The improved structure is shown below.

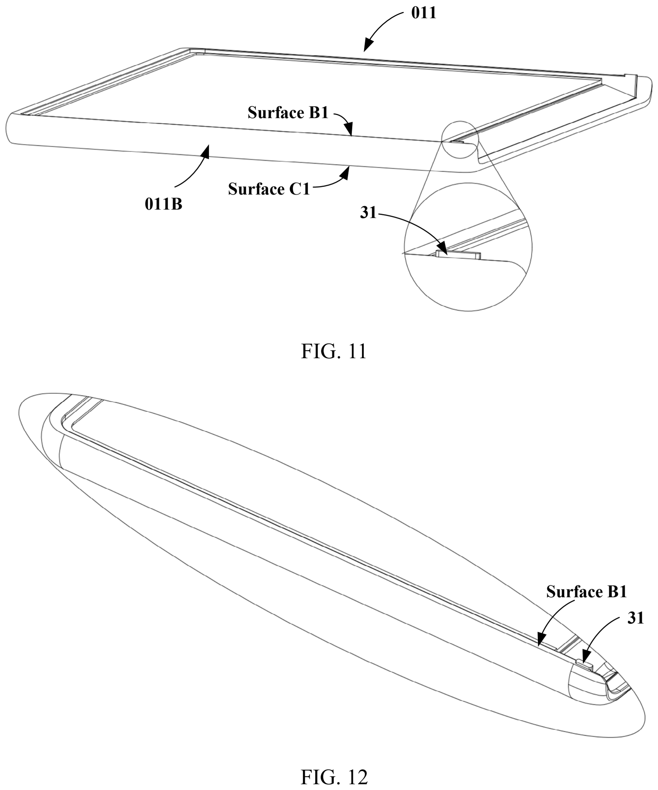

FIG. 11 and FIG. 12 each are a diagram of a structure of the first middle frame 011 observed from a different angle of view. In the first middle frame 011, the surface B1 of the first side frame 011B includes a first protrusion part 31, that is, the first protrusion part 31 protrudes from the surface B1.

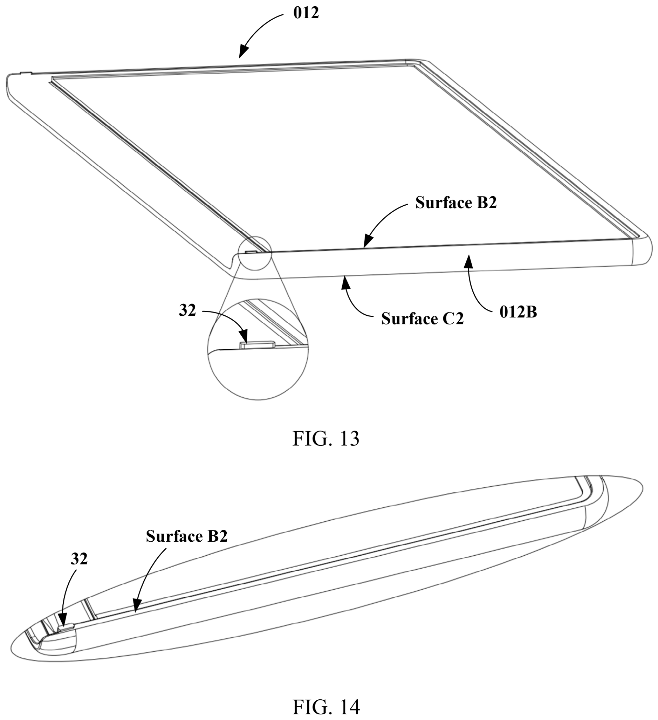

FIG. 13 and FIG. 14 each are a diagram of a structure of the second middle frame 012 observed from a different angle of view. In the second middle frame 012, the surface B2 of the second side frame 012B includes a second protrusion part 32, that is, the second protrusion part 32 protrudes from the surface B2.

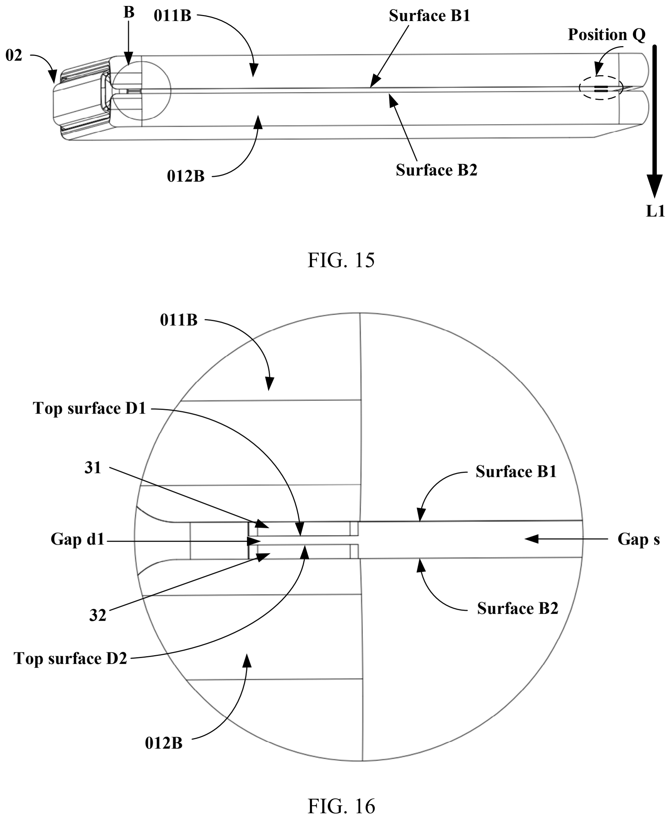

FIG. 15 is a diagram of a structure of the first middle frame 011 and the second middle frame 012 of the foldable display terminal 100 in the folded state. FIG. 16 is an enlarged view of a position B in FIG. 15. With reference to FIG. 15 and FIG. 16, in a process in which the foldable display terminal 100 performs switching from the flattened state to the folded state, the surface B1 of the first side frame 011B and the surface B2 of the second side frame 012B gradually approach each other until the surface B1 and the surface B2 face each other, and a gap s exists between the surface B1 and the surface B2. In addition, when the surface B1 of the first side frame 011B and the surface B2 of the second side frame 012B gradually approach each other, the first protrusion part 31 and the second protrusion part 32 also gradually approach each other until the first protrusion part 31 and the second protrusion part 32 face each other shown in FIG. 16, and a gap d1 also exists between the first protrusion part 31 and the second protrusion part 32.

Still refer to FIG. 16. The first protrusion part 31 has a top surface D1 away from the surface B1, and the second protrusion part 32 has a top surface D2 away from the surface B2. When the foldable display terminal 100 is in the folded state, the top surface of D1 faces the top surface of D2, and the gap d1 exists between the top surface of D1 and the top surface of D2.

In a case in which the foldable display terminal 100 falls to the ground in the scenario shown in FIG. 15, that is, the foldable display terminal 100 in the folded state falls in a direction L1 that is shown in FIG. 15 and that is parallel to the thickness direction of the foldable display terminal 100, in the thickness direction of the foldable display terminal 100, the first protrusion part 31 protrudes relative to the surface B1, the second protrusion part 32 protrudes relative to the surface B2, and an orthographic projection of the first protrusion part 31 on the surface B2 at least partially overlaps an orthographic projection of the second protrusion part 32 on the surface B2. In this way, when the foldable display terminal falls to the ground, the top surface D1 and the top surface D2 in FIG. 16 can abut against each other for mutual support, so that a falling amount of the first middle frame 011 or the second middle frame 012 caused by impact can be reduced. For example, when the second middle frame 012 shown in FIG. 16 is first grounded, the falling amount of the first middle frame 011 can be reduced, to reduce a large squeezing force generated through abutment between the surface B1 and the surface B2, and protect the internal structure of the entire foldable display terminal from further squeezing and impact.

To improve abutting stability between the first protrusion part 31 and the second protrusion part 32, as shown in FIG. 16, the top surface D1 of the first protrusion part 31 and the top surface D2 of the second protrusion part 32 each may be a plane. Therefore, compared with line-to-line touch or point-to-point touch, surface-to-surface touch of the two protrusion parts can increase a contact area, improve contact stability, further reduce a falling amplitude of the middle frame, and further reduce a force of mutual squeezing between the two middle frames.

There are a plurality of cases in which the first protrusion part 31 and the second protrusion part 32 are disposed. For example, the protrusion part may be disposed at a position close to the hinge structure 02 shown in FIG. 15, or may be disposed at another position. For example, the protrusion part may be disposed at a position Q shown in FIG. 15. Alternatively, the protrusion part may be disposed at a position close to the hinge structure 02 shown in FIG. 15, or may be disposed at a position Q shown in FIG. 15.

If the first protrusion part 31 and the second protrusion part 32 are disposed at positions close to the hinge structure 02, an appearance and aesthetics are basically not greatly affected.

Still refer to FIG. 16. The gap between the top surface D1 and the top surface D2 is d1. In some examples, d1≤1 mm. For example, 0.1 mm≤d1≤1 mm. For another example, 0.1 mm≤d1≤0.8 mm. For another example, 0.1 mm≤d1≤0.3 mm. Alternatively, 0.1 mm≤d1/s≤0.8 mm, 0.1 mm≤d1/s≤0.5 mm, or the like.

If the gap d1 is large, when the foldable display terminal falls, the first protrusion part and the second protrusion part may fail to abut against each other for support.

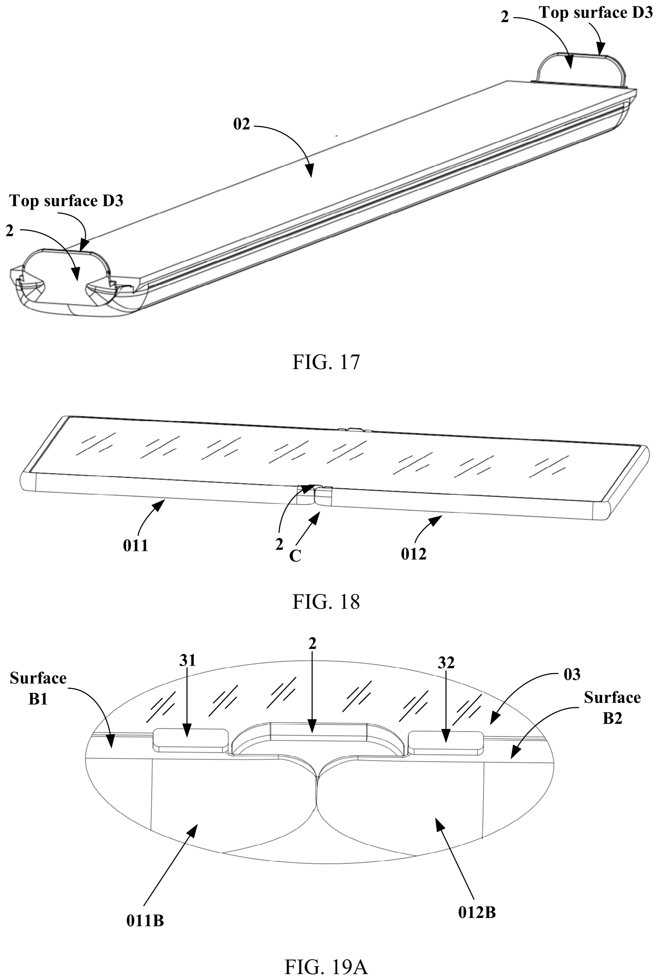

FIG. 17 is a diagram of a structure of the hinge structure 02 according to this embodiment of this application. Shielding members 2 are respectively disposed at two opposite ends of the hinge structure 02 in an axis direction of the hinge structure 02.

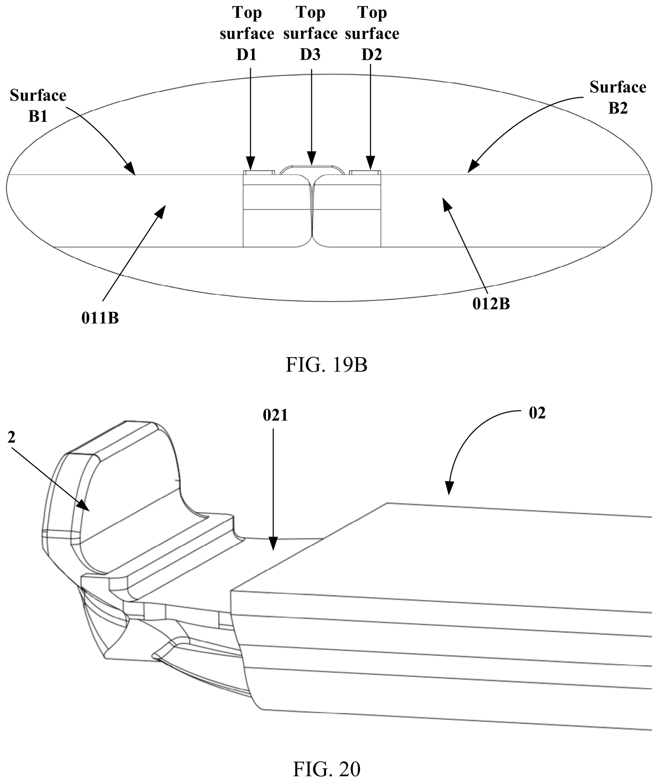

FIG. 18 is a diagram of a structure of the foldable display terminal 100 in the flattened state in which the foldable display 03 is disposed on the first middle frame 011 and the second middle frame 012 according to this embodiment of this application. FIG. 19A and FIG. 19B each are a diagram of a partial structure in a direction C shown in FIG. 18.

With reference to FIG. 18, FIG. 19A, and FIG. 19B, when the foldable display terminal 100 is in the flattened state, at least parts of the hinge structure 02 and the shielding member 2 are hidden in the accommodating groove 1 between the first middle frame 011 and the second middle frame 012.

Return to FIG. 17. The shielding member 2 has a top surface D3 away from the hinge structure 02. When the foldable display terminal 100 is in the flattened state shown in FIG. 18, FIG. 19A, and FIG. 19B, the top surface D3 of the shielding member 2 protrudes from the top surface D1 of the first protrusion part 31 and the top surface D2 of the second protrusion part 32, or the top surface D3 of the shielding member 2 is basically flush with the top surface D1 of the first protrusion part 31 and the top surface D2 of the second protrusion part 32.

To protect the foldable display, as shown in FIG. 19A, the top surface D1 of the first protrusion part 31, the top surface D2 of the second protrusion part 32, and the top surface D3 of the shielding member all protrude from the foldable display 03. In this way, when the foldable display terminal 100 in the flattened state falls, and the foldable display 03 faces the ground, the top surface D1 of the first protrusion part 31, the top surface D2 of the second protrusion part 32, and the top surface D3 of the shielding member are first grounded, to protect the foldable display 03, and prevent the foldable display 03 from being damaged by a large impact force.

In some examples, the hinge structure 02 may include a main shaft and another transmission structure, and the first middle frame 011 and the second middle frame 012 can rotate relative to the main shaft by using some transmission structures.

To simplify an assembly process, as shown in FIG. 20, the shielding member 2 and the main shaft 021 in the hinge structure 02 may be an integrally formed structural part. In this way, a structure of the foldable display terminal can be simplified, and an assembly process can be further simplified compared with a separately disposed shielding member (which may also be referred to as a T-shaped block), to reduce a phenomenon that a product is defective due to poor assembly.

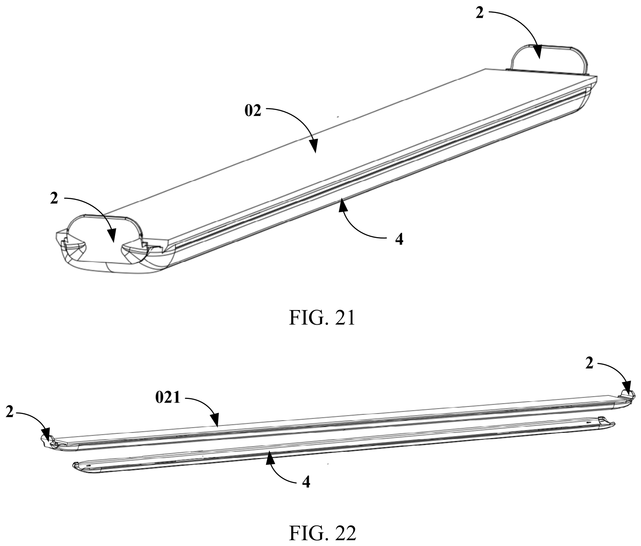

In some structures, refer to FIG. 21 and FIG. 22. FIG. 21 is a diagram of an assembly position relationship among the hinge structure 02, the shielding member 2, and a decoration member 4. FIG. 22 is an exploded view of FIG. 21.

As shown in FIG. 21 and FIG. 22, the decoration member 4 covers an outer side of the hinge structure 02. In other words, the decoration member 4 is disposed on an outside part, visible to the user, of the display terminal.

When the foldable display terminal is in the flattened state, in the thickness direction of the foldable display terminal, the shielding member 2 extends in a direction away from the decoration member 4, that is, extends in a direction facing the foldable display.

When the foldable display terminal is in the folded state, at least parts of the decoration member 4 and the shielding member 2 are exposed outside the foldable display terminal.

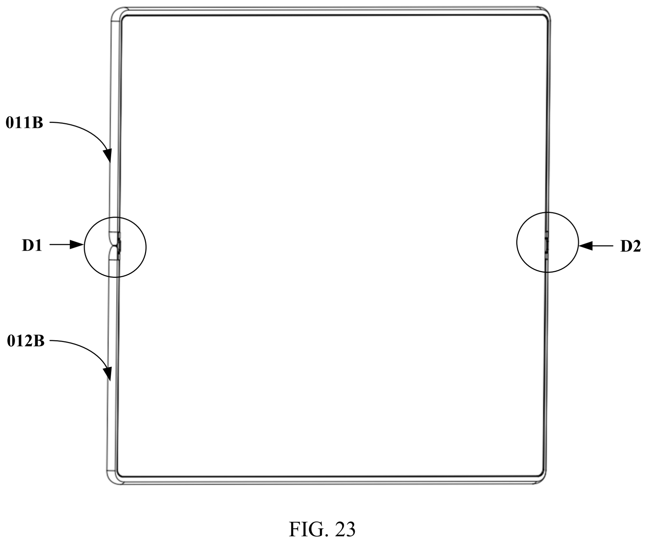

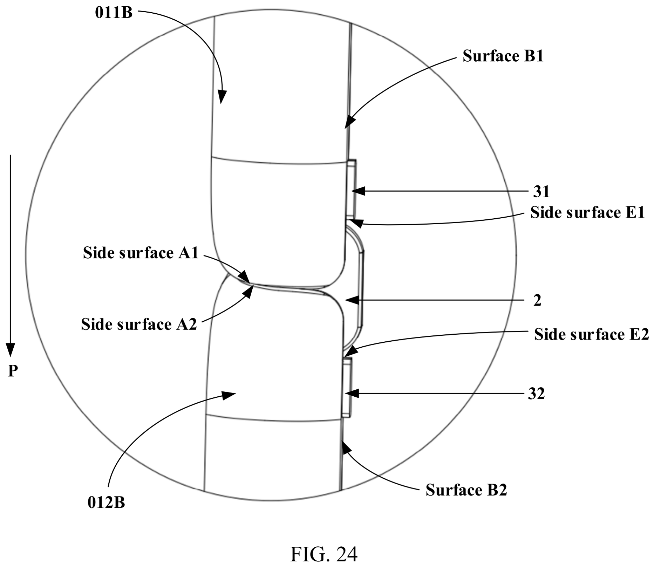

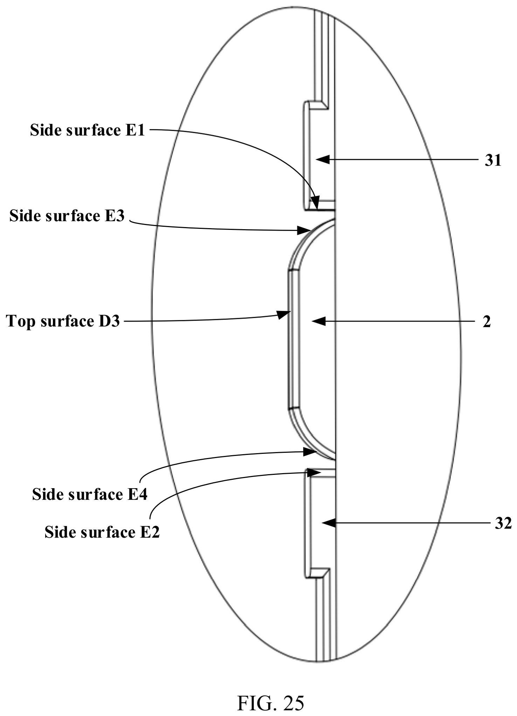

Refer to FIG. 23, FIG. 24, and FIG. 25. FIG. 23 is a diagram of a structure of the foldable display terminal in the flattened state. FIG. 24 is an enlarged view of a position D1 or a position D2 in FIG. 23. FIG. 25 is a diagram of FIG. 24 from another angle of view.

With reference to FIG. 23 to FIG. 25, the first protrusion part 31 includes a side surface E1, the second protrusion part 32 includes a side surface E2, and the shielding member 2 includes the top surface D3, a side surface E3, and a side surface E4. When the foldable display terminal is in the flattened state, the first protrusion part 31, the shielding member 2, and the second protrusion part 32 are sequentially arranged in a direction in which the first middle frame 011 points to the second middle frame 012 (a direction P in FIG. 24), and as shown in FIG. 25, the side surface E1 of the first protrusion part 31 faces the side surface E3 of the shielding member 2, the side surface E2 of the second protrusion part 32 faces the side surface E4 of the shielding member 2, a gap exists between the side surface E1 and the side surface E3, and a gap exists between the side surface E2 and the side surface E4.

That is, when the foldable display terminal is in the flattened state, in the direction in which the first middle frame 011 points to the second middle frame 012, the first protrusion part 31 and the shielding member 2 are spaced from each other, and the second protrusion part 32 and the shielding member 2 are spaced from each other.

In this way, when the foldable display terminal is in the flattened state and falls in the direction in which the first middle frame 011 points to the second middle frame 012 shown in FIG. 23, the side surface E1 of the first protrusion part 31 and the side surface E3 of the shielding member 2 may abut against each other for mutual support, and the side surface E2 of the second protrusion part 32 and the side surface E4 of the shielding member 2 may abut against each other for mutual support, to reduce a large squeezing force generated through abutment between the side surface A1 of the first side frame 011B and the side surface A2 of the second side frame 012B, and protect the internal structure of the entire foldable display terminal from further squeezing and impact. Especially, when an area of the side surface A1 of the first side frame 011B and an area of the side surface A2 of the second side frame 012B are small, the protrusion part disposed on the side frame and the shielding member at an end of the hinge structure support each other, so that mutual squeezing and confrontation between the first middle frame 011 and the second middle frame 012 can be obviously reduced.

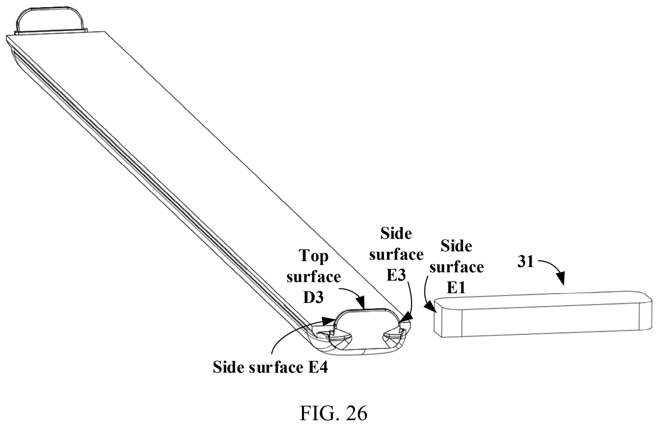

FIG. 26 shows a position relationship between the shielding member 2 and the first protrusion part 31 in a case in which the foldable display terminal is in the flattened state. To improve stability of confrontation between the first protrusion part 31 and the shielding member 2, the side surface E1 that is of the first protrusion part 31 and that is in abutting contact with the side surface E3 of the shielding member 2 may be a plane. Similarly, the side surface E3 that is of the second protrusion part 32 and that is in abutting contact with the side surface E4 of the shielding member 2 may also be a plane.

In the examples shown in FIG. 24 and FIG. 25, the gap between the side surface E3 and the side surface E1 is d2. In some examples, d2≤1 mm. For example, 0.1 mm≤d2≤1 mm. For another example, 0.1 mm≤d2≤0.8 mm. For another example, 0.1 mm≤d2≤0.3 mm.

The gap between the side surface E2 and the side surface E4 is d3. In some examples, d3≤1 mm. For example, 0.1 mm≤d3≤1 mm. For another example, 0.1 mm≤d3≤0.8 mm. For another example, 0.1 mm≤d3≤0.3 mm.

If the gap d2 and the gap d3 are large, when the foldable display terminal falls, the first protrusion part and the shielding member may fail to abut against each other for support, or the second protrusion part and the shielding member may fail to abut against each other for support.

In the foregoing embodiment, strength of the first protrusion part 31 or the second protrusion part 32 cannot be excessively large. Instead, the protrusion part (the first protrusion part 31 or the second protrusion part 32) needs to be slightly deformed in a process in which the first protrusion part 31 or the second protrusion part 32 abuts against and collides with the shielding member 2. For example, when the first protrusion part 31 or the second protrusion part 32 abuts against and collides with the shielding member 2, a deformation amount is approximately 0.05 mm or less than 0.05 mm. In this way, the slightly deformed supporting part can absorb energy generated by falling impact, and reduce energy impact on the internal structure of the entire foldable display terminal.

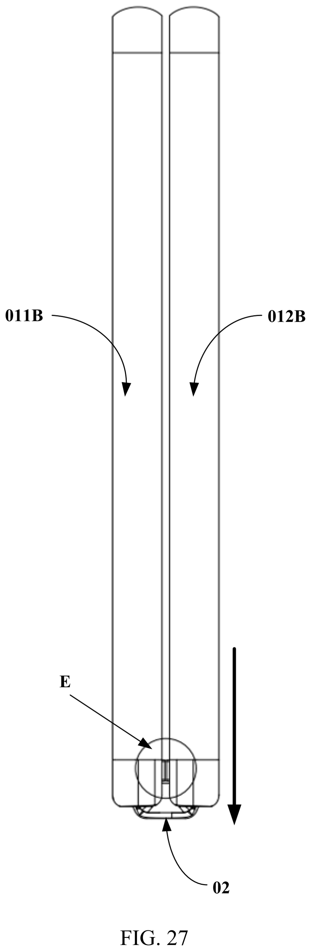

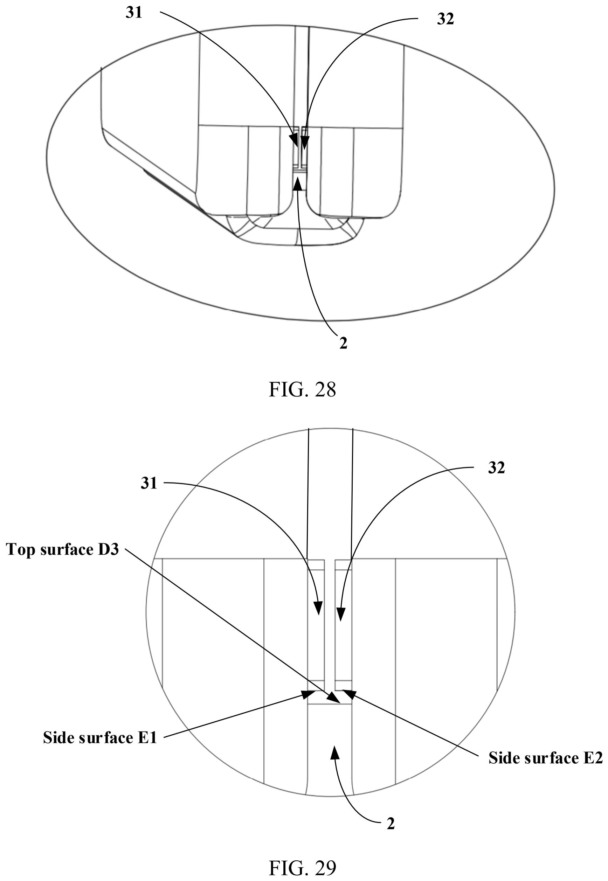

The foregoing shows two different falling scenarios of the foldable display terminal. In some scenarios, the foldable display terminal may alternatively fall in a manner shown in FIG. 27. To be specific, when the foldable display terminal is in the folded state, the hinge structure 02 faces the ground. To avoid damage to the internal component in the falling scenario, FIG. 28 is an enlarged view of a position E in FIG. 27. FIG. 28 and FIG. 29 clearly display a position between the first protrusion part 31 and the shielding member 2 in the foldable display terminal in the folded state. When the foldable display terminal is in the folded state, the side surface E1 of the first protrusion part 31 faces the top surface D3 of the shielding member 2, a gap exists between the side surface E1 and the top surface D3, the side surface E2 of the second protrusion part 32 faces the top surface D3 of the shielding member 2, and a gap exists between the side surface E2 and the top surface D3.

An orthographic projection of the first protrusion part 31 on a reference surface (an X-O-Z plane) at least partially overlaps an orthographic projection of the shielding member 2 on the reference surface (X-O-Z plane), and an orthographic projection of the second protrusion part 32 on the reference surface (X-O-Z plane) at least partially overlaps the orthographic projection of the shielding member 2 on the reference surface (X-O-Z plane). In this way, when the foldable display terminal falls to the ground in the scenario shown in FIG. 27 (shown by a black arrow), both the side surface E1 of the first protrusion part 31 and the side surface E2 of the second protrusion part 32 abut against the top surface D3 of the shielding member 2 for mutual support, to reduce falling amounts of the first middle frame 011 and the second middle frame 012, and protect the internal structure of the entire foldable display terminal from further squeezing and impact.

The reference surface X-O-Z may be understood as being perpendicular to the surface B1 of the first middle frame, or perpendicular to the surface B2 of the second middle frame, and perpendicular to the axis direction of the hinge structure 02.

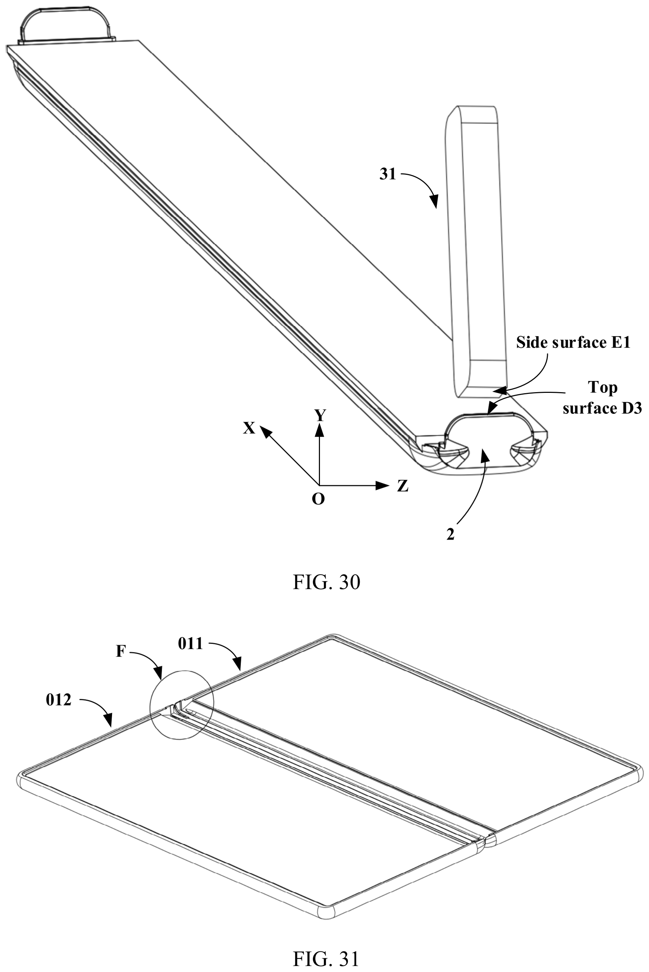

As shown in FIG. 30, to improve abutting stability between the side surface E1 of the first protrusion part 31 and the top surface D3 of the shielding member 2, the side surface E1 of the first protrusion part 31 may be a plane. Similarly, the side surface E2 of the second protrusion part 32 may be a plane. This can increase a contact area, further reduce a falling amplitude of the middle frame, and reduce a force of mutual squeezing between the two middle frames.

In the examples shown in FIG. 28 and FIG. 29, a gap between the side surface E1 and the top surface D3 is d4. In some examples, d4≤1 mm. For example, 0.1 mm≤d4≤1 mm. For another example, 0.1 mm≤d4≤0.8 mm. For another example, 0.1 mm≤d4≤0.3 mm.

A gap between the side surface E2 and the top surface D3 may be equal to or not equal to the gap d4.

Based on the foregoing descriptions of different falling scenarios of the foldable display terminal, it can be learned that, in this embodiment of this application, the protrusion part is disposed on a surface that is of the middle frame and that is close to the hinge structure, and the protrusion part may cooperate with the shielding member at the end of the hinge structure, or the protrusion part cooperates with another protrusion part. In this way, when the display terminal falls in different directions, the supporting part and the shielding member may abut against each other for mutual support, or the protrusion part and the another protrusion part may abut against each other for mutual support, to reduce the falling amplitude of the middle frame, reduce a degree of squeezing between the two middle frames, and reduce kinetic energy of the display terminal generated when the display terminal is grounded. This can avoid large impact on an internal component and structure, make the entire foldable display terminal more drop-resistant, and improve use performance of the entire display terminal.

The first protrusion part 31 and the first side frame 011B may be an integrally formed structure. For example, the first side frame 011B including the first protrusion part 31 may be integrally formed by using a casting process. For example, the first side frame 011B that includes the first protrusion part 31 and that is integrally formed through casting may be a metal structural part. From the perspective of a manufacturing process, the manufacturing process of the middle frame is not more complicated due to addition of the protrusion part. From the perspective of an assembly process, an integrated design of the protrusion part and the side frame does not complicate the assembly process of the entire display terminal.

In some other structures, the first protrusion part 31 may be disposed on the first side frame 011B by using an adhesive layer.

In some examples, the first protrusion part 31 or the second protrusion part 32 may be a structure close to a cuboid. Certainly, another shape may also be selected.

For structures of the first protrusion part 31, the second protrusion part 32, and the shielding member, the foregoing descriptions are merely based on an example in which the first protrusion part 31, the second protrusion part 32, and the shielding member are located at one end of the hinge structure. In a display terminal that can be implemented, the foregoing structure in which the protrusion part and the shielding member support each other may be used at both ends of the hinge structure.

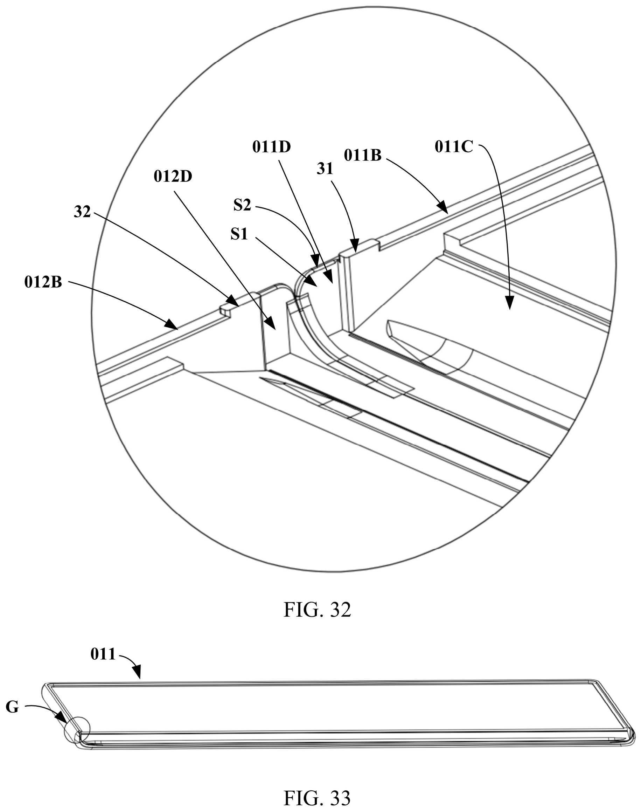

FIG. 31 shows an assembly relationship among the shielding member 2, the first side frame 011B and the second side frame 012B. FIG. 32 is an enlarged view of a position F in FIG. 31. With reference to FIG. 31 and FIG. 32, at a position that is of the first side frame 011B and that is close to the first protrusion part 31, an inner wall surface S1 used to enclose the mounting groove 011C is recessed toward an outer wall surface S2, to form a groove 011D; and at a position that is of the second side frame 012B and that is close to the second protrusion part 32, an inner wall surface S3 used to enclose the mounting groove 012C is recessed toward an outer wall surface S4, to form a groove 012D. The shielding member 2 is disposed in space enclosed by the groove 011D and the groove 012D.

The inner wall surface S1 of the first side frame 011B is an inner wall surface that is of the side frame and that is close to the middle frame body, and the outer wall surface S2 is an appearance surface of the display terminal. Similarly, the inner wall surface S3 of the second side frame 012B is an inner wall surface that is of the side frame and that is close to the middle frame body, and the outer wall surface S4 is an appearance surface of the display terminal.

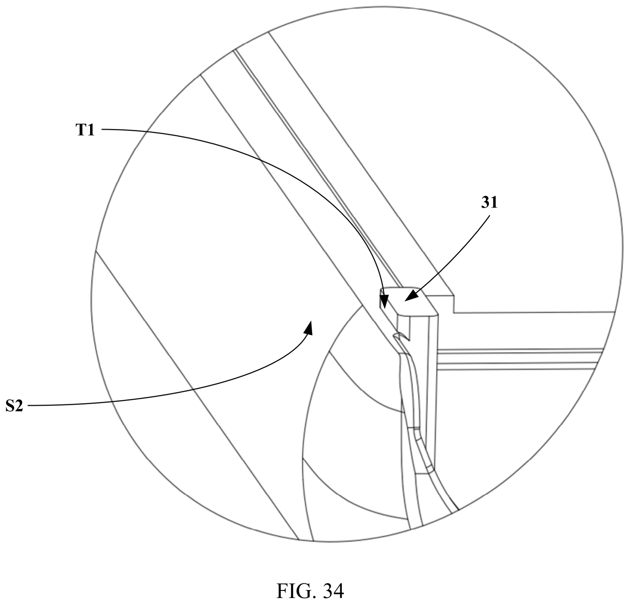

To improve an appearance and aesthetics, as shown in FIG. 33 and FIG. 34, FIG. 34 is an enlarged view of a position G in FIG. 33. A gap exists between the outer wall surface S2 and a wall surface T1 that is of the first protrusion part 31 and that faces outside of the first middle frame 011. To be specific, the wall surface T1 that is of the first protrusion part 31 and that faces outside of the first middle frame 011 is not flush with the outer wall surface S2, but shrinks toward inside of the product. In this way, the first protrusion part 31 may be basically invisible from outside of the product.

A gap also exists between the outer wall surface S4 and a wall surface that is of the second protrusion part 31 and that faces outside of the second middle frame 012. Similarly, an appearance and aesthetics are not affected due to addition of the protrusion part.

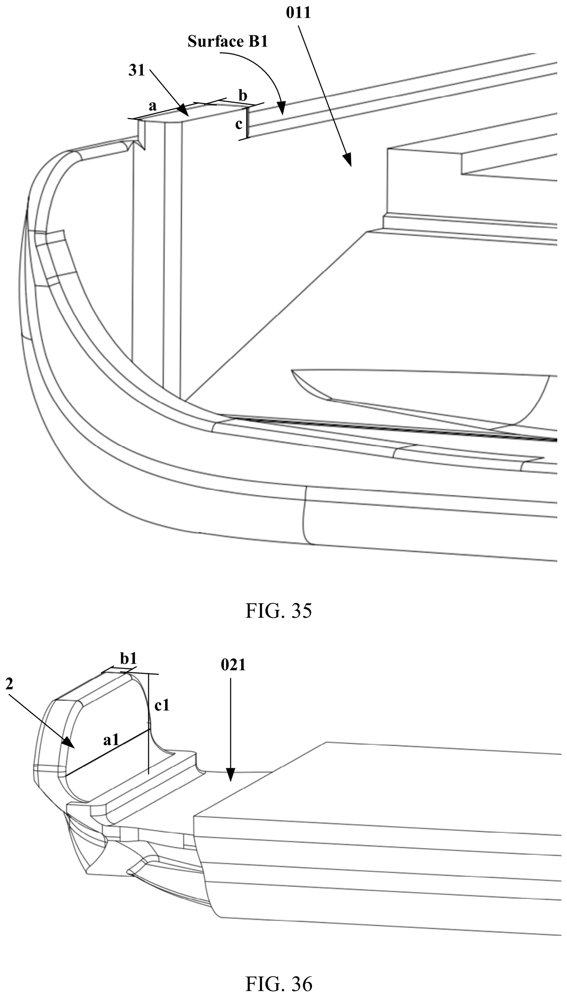

With reference to FIG. 35 and FIG. 36 together, FIG. 35 shows a length size a, a width size b, and a height size c of the first protrusion part 31, and FIG. 36 shows a length size a1, a width size b1, and a height size c1 of the shielding member. The length size a and the length size a1 are sizes in a direction in which the first middle frame 011 and the second middle frame 012 are arranged when the foldable display terminal is in the flattened state. The width size b and the width size b2 are sizes perpendicular to the direction in which the first middle frame 011 and the second middle frame 012 are arranged and parallel to a surface on which the foldable display is located. The height size c and the height size c2 are sizes parallel to a thickness direction of the first middle frame 011 or the second middle frame 012.

To improve a support effect, the width size b of the supporting part may be equal to or close to the width size b1 of the shielding member 2.

In addition, in embodiments of this application, the length size a, the width size b, and the height size c of the supporting part, and the length size a1, the width size b1, and the height size c1 of the shielding member are not specially limited, provided that the parts can abut against each other for mutual support in different falling scenarios in the foregoing examples.

In descriptions of this specification, specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable display terminal, comprising:
a first middle frame and a second middle frame; and
a hinge structure, wherein the first middle frame and the second middle frame are disposed on two sides of the hinge structure, and the first middle frame and the second middle frame rotate toward each other through the hinge structure, so that the foldable display terminal is capable of performing switching between a flattened state and a folded state, wherein when the foldable display terminal is in the flattened state, the first middle frame and the second middle frame are in a flattened disposition;
an edge of the first middle frame comprises a first top surface, an edge of the second middle frame comprises a second top surface, the first top surface comprises a first protrusion part, and the second top surface comprises a second protrusion part; and
when the foldable display terminal is in the folded state, the first top surface faces the second top surface, a gap exists between the first top surface and the second top surface, the first protrusion part faces the second protrusion part, and a gap exists between the first protrusion part and the second protrusion part.

2. The foldable display terminal according to claim 1, wherein
the first protrusion part is disposed at a position that is of the first top surface and that is close to an end of the hinge structure; and
the second protrusion part is disposed at a position that is of the second top surface and that is close to an end of the hinge structure.

3. The foldable display terminal according to claim 1 or 2, wherein
the first protrusion part comprises a first side surface, and the second protrusion part comprises a second side surface;
the end of the hinge structure comprises a shielding member, and the shielding member comprises a third top surface, a third side surface, and a fourth side surface;
the first protrusion part and the shielding member are spaced from each other;
the second protrusion part and the shielding member are spaced from each other; and
when the foldable display terminal is in the flattened state, the first protrusion part, the shielding member, and the second protrusion part are sequentially arranged in a direction in which the first middle frame points to the second middle frame, the first side surface faces the third side surface, the second side surface faces the fourth side surface, a gap exists between the first side surface and the third side surface, and a gap exists between the second side surface and the fourth side surface.

4. The foldable display terminal according to claim 3, wherein when the foldable display terminal is in the folded state, the first side surface faces the third top surface, the second side surface faces the third top surface, a gap exists between the first side surface and the third top surface, and a gap exists between the second side surface and the third top surface.

5. The foldable display terminal according to claim 3 or 4, wherein the hinge structure comprises a main shaft;
an end of the main shaft comprises the shielding member; and
when the foldable display terminal is in the flattened state, the first top surface and the second top surface are flush with the third top surface.

6. The foldable display terminal according to claim 5, wherein the shielding member and the main shaft are an integrally formed member.

7. The foldable display terminal according to any one of claims 3 to 6, wherein the foldable display terminal further comprises a decoration member, and the decoration member covers an outer side of the hinge structure; and
when the foldable display terminal is in the flattened state, in a thickness direction of the foldable display terminal, the shielding member extends in a direction away from the decoration member; or
when the foldable display terminal is in the folded state, at least parts of the decoration member and the shielding member are exposed outside the foldable display terminal.

8. The foldable display terminal according to any one of claims 3 to 7, wherein a first mounting groove is provided at a position that is of the first middle frame and that is close to the second middle frame, a second mounting groove is provided at a position that is of the second middle frame and that is close to the first middle frame, and the hinge structure is disposed in an accommodating groove enclosed by the first mounting groove and the second mounting groove;
at a position that is of the first middle frame and that is close to the first protrusion part, a first inner wall surface used to enclose the first mounting groove is recessed toward a first outer wall surface, to form a first groove;
at a position that is of the second middle frame and that is close to the second protrusion part, a second inner wall surface used to enclose the second mounting groove is recessed toward a second outer wall surface, to form a second groove;
the shielding member is located in an accommodating groove enclosed by the first groove and the second groove; and
the first inner wall surface is opposite to the first outer wall surface, and the second inner wall surface is opposite to the second outer wall surface.

9. The foldable display terminal according to claim 8, wherein a gap exists between the first outer wall surface and a wall surface that is of the first protrusion part and that faces outside of the first middle frame.

10. The foldable display terminal according to any one of claims 1 to 9, wherein
the foldable display terminal further comprises a foldable display, wherein the foldable display is located on a side facing the first top surface and the second top surface; and
when the foldable display terminal is in the flattened state, a surface that is of the first protrusion part and that is away from the first top surface protrudes from the foldable display, and a surface that is of the second protrusion part and that is away from the second top surface protrudes from the foldable display.

11. The foldable display terminal according to any one of claims 1 to 10, wherein
when the foldable display terminal is in the folded state, an orthographic projection of the first protrusion part on the second top surface at least partially overlaps an orthographic projection of the second protrusion part on the second top surface.

12. The foldable display terminal according to any one of claims 1 to 11, wherein the end of the hinge structure comprises the shielding member; and when the foldable display terminal is in the folded state, an orthographic projection of the first protrusion part on a reference surface at least partially overlaps an orthographic projection of the shielding member on the reference surface; and
the reference surface is perpendicular to the first top surface, and is parallel to an axial direction of the hinge structure.

13. The foldable display terminal according to any one of claims 1 to 12, wherein the first protrusion part and the first middle frame are an integrally formed member.

14. A middle frame, wherein the middle frame is disposed on one side of a hinge structure in a foldable display terminal and is capable of rotating through the hinge structure, and the middle frame comprises:
a middle frame body; and
a side frame, wherein the side frame is connected to an outer circumferential edge of the middle frame body;
the side frame comprises a first top surface, and the first top surface comprises a first protrusion part; and
when the middle frame rotates to a folded state through the hinge structure, the first top surface faces a second top surface of another middle frame, a gap exists between the first top surface and the second top surface, the first protrusion part faces a second protrusion part on the second top surface, and a gap exists between the first protrusion part and the second protrusion part.

15. The middle frame according to claim 14, wherein the first protrusion part is disposed at a position that is of the first top surface and that is close to an end of the hinge structure.

16. The middle frame according to claim 14 or 15, wherein the first protrusion part and the side frame are an integrally formed member.

17. The middle frame according to any one of claims 14 to 16, wherein the side frame and the middle frame body are an integrally formed member.

18. The middle frame according to any one of claims 14 to 17, wherein a first mounting groove is provided at a position that is of the side frame and that is close to the hinge structure, and the first mounting groove is configured to accommodate the hinge structure; and
at a position that is of the side frame and that is close to the first protrusion part, a first inner wall surface used to enclose the first mounting groove is recessed toward a first outer wall surface, to form a first groove, the first groove is configured to dispose a shielding member located at the end of the hinge structure, the first inner wall surface is opposite to the first outer wall surface, and a gap exists between the first outer wall surface and a wall surface that is of the first protrusion part and that faces outside of the middle frame.
